# EUROPEAN PATENT SPECIFICATION

(11) **EP 1 452 922 B1**
(45) Date of publication and mention of the grant of the patent: **07.01.2015**
(21) Application number: 02775499.3
(22) Date of filing: 05.11.2002
(51) Int. Cl.: G03F 7/40, H01L 21/027

(54) **METHOD FOR FORMING FINE PATTERN**
VERFAHREN ZUR BILDUNG EINES FEINEN MUSTERS
PROCEDE DE FORMATION D'UN MOTIF FIN

(30) Priority: 05.11.2001 JP 2001339310
(43) Date of publication of application: 01.09.2004
(73) Proprietor: TOKYO OHKA KOGYO CO., LTD., Kawasaki-shi, Kanagawa 211-0012 (JP)
(72) Inventor: SHINBORI, Hiroshi, Kawasaki-shi, Kanagawa 210-0924 (JP); SUGETA, Yoshiki, Yokohama-shi, Kanagawa 234-0055 (JP); KANEKO, Fumitake, Koza-gun, Kanagawa 253-0111 (JP); TACHIKAWA, Toshikazu, Kangawa, 251-0042 (JP)
(74) Representative: Hoffmann Eitle
(86) International application number: PCT/JP2002/011497
(87) International publication number: WO 2003/040831

(56) References cited:
- EP-A- 1 489 463
- JP-A- 2001 109 165
- JP-A- 2002 006 512
- JP-A- 2002 023 389
- US-A- 5 858 620
- US-A1- 5 858 620
- US-B1- 6 180 320

## Description

### Technical Field

This invention relates to a method of forming fine patterns in the field of photolithographic technology. More particularly, the invention relates to a method of forming or defining fine-line patterns, such as hole patterns and trench patterns, that can meet today's requirements for higher packing densities and smaller sizes of semiconductor devices.

### Background Art

In the manufacture of electronic components such as semiconductor devices and liquid-crystal devices, there is employed the photolithographic technology which, in order to perform a treatment such as etching on the substrate, first forms a film (photoresist layer) over the substrate using a so-called radiation-sensitive photoresist which is sensitive to activating radiations, then performs exposure of the film by selective illumination with an activating radiation, performs development to dissolve away the photoresist layer selectively to form an image pattern (photoresist pattern), and forms a variety of patterns including contact providing patterns such as a hole pattern and a trench pattern using the photoresist pattern as a protective layer (mask pattern).

With the recent increase in the need for higher packing densities and smaller sizes of semiconductor devices, increasing efforts are being made to form sufficiently fine-line patterns and submicron-electronic fabrication capable of forming patterns with linewidths of no more than 0.20 µm is currently required. As for the activating light rays necessary in the formation of mask patterns, short-wavelength radiations such as KrF, ArF and F₂ excimer laser beams and electron beams are employed. Further, active R&D efforts are being made to find photoresist materials as mask pattern formers that have physical properties adapted to those short-wavelength radiations.

In addition to those approaches for realizing submicron-electronic fabrication which are based on photoresist materials, active R&D efforts are also being made on the basis of pattern forming method with a view to finding a technology that can provide higher resolutions than those possessed by photoresist materials.

For example, JP-5-166717A discloses a method of forming fine patterns which comprises the steps of defining patterns (=photoresist-uncovered patterns) into a pattern-forming resist on a substrate, then coating over entirely the substrate with a mixing generating resist that is to be mixed with said pattern-forming resist, baking the assembly to form a mixing layer on both sidewalls and the top of the pattern-forming resist, and removing the non-mixing portions of said mixing generating resist such that the feature size of the photoresist-uncovered pattern is reduced by an amount comparable to the dimension of said mixing layer. JP-5-241348 discloses a pattern forming method comprising the steps of depositing a resin, which becomes insoluble in the presence of an acid, on a substrate having formed thereon a resist pattern containing an acid generator, heat treating the assembly so that the acid is diffused from the resist pattern into said resin insoluble in the presence of an acid to form a given thickness of insolubilized portion of the resist near the interface between the resin and the resist pattern, and developing the resist to remove the resin portion through which no acid has been diffused, thereby ensuring that the feature size of the pattern is reduced by an amount comparable to the dimension of said given thickness.

However, in these methods, it is difficult to control the thickness of layers to be formed on the sidewalls of resist patterns. In addition, the in-plane heat dependency of wafers is as great as ten-odd nanometers per degree Celsius, so it is extremely difficult to keep the in-plane uniformity of wafers by means of the heater employed in current fabrication of semiconductor devices and this leads to the problem of occurrence of significant variations in pattern dimensions.

Another approach known to be capable of reducing pattern dimensions is by fluidizing resist patterns through heat treatment and the like. For example, JP-1-307228A discloses a method comprising the steps of forming a resist pattern on a substrate and applying heat treatment to deform the cross-sectional shape of the resist pattern, thereby defining a fine pattern. In addition, JP-4-364021A discloses a method comprising the steps of forming a resist pattern and heating it to fluidize the resist pattern, thereby changing the dimensions of its resist pattern to form or define a fine-line pattern.

In these methods, the wafer's in-plane heat dependency is only a few nanometers per degree Celsius and is not very problematic. On the other hand, it is difficult to control the resist deformation and fluidizing on account of heat treatment, so it is not easy to provide a uniform resist pattern in a wafer's plane.

An evolved version of those methods is disclosed in JP-7-45510A and it comprises the steps of forming a resist pattern on a substrate, forming a stopper resin on the substrate to prevent excessive thermal fluidizing of the resist pattern, then applying heat treatment to fluidize the resist so as to change the dimensions of its pattern, and thereafter removing the stopper resin to form or define a fine-line pattern. As the stopper resin, a water-soluble resin, specifically, polyvinyl alcohol is employed. However, polyvinyl alcohol is not highly soluble in water and cannot be readily removed completely by washing with water, introducing difficulty in forming a pattern of good profile. The pattern formed is not completely satisfactory in terms of stability over time. In addition, polyvinyl alcohol cannot be applied efficiently by coating. Because of these and other problems, the method disclosed in JP-7-45510 has yet to be adopted commercially.

JP 2001-281886A discloses a method comprising the steps of covering a surface of a resist pattern with an acidic film made of a resist pattern size reducing material containing a water-soluble resin, rendering the surface layer of the resist pattern alkali-soluble, then removing said surface layer and the acidic film with an alkaline solution to reduce the feature size of the resist pattern. JP-2002-184673A discloses a method comprising the steps of forming a resist pattern on a substrate, then forming a film containing a water-soluble film forming component on said resist pattern, heat treating said resist pattern and film, and immersing the assembly in an aqueous solution of tetramethylammonium hydroxide, thereby forming a fine-line resist pattern without involving a dry etching step. However, both methods are simply directed to reducing the size of resist trace patterns themselves and therefore are totally different from the present invention in object.

### Disclosure of Invention

An object of the present invention is to provide a method of forming fine patterns on a substrate having photoresist patterns (mask patterns) as it is covered with an over-coating agent. The method has high ability to control pattern dimensions and provides fine-line patterns that have a satisfactory profile and satisfy the characteristics required of semiconductor devices.

In order to attain this object, the present invention provides a method of forming fine-line patterns according to claim 1.

In a preferred embodiment, the over-coating agent for forming fine patterns contains a water-soluble polymer.

### Best Mode for Carrying Out the Invention

The method of preparing the substrate used in the present invention having photoresist patterns thereon is not limited to any particular type and it can be prepared by conventional methods employed in the fabrication of semiconductor devices, liquid-crystal display devices, magnetic heads and microlens arrays. In an exemplary method, a photoresist composition of chemically amplifiable or other type is spin-or otherwise coated on a substrate such as a silicon wafer and dried to form a photoresist layer, which is illuminated with an activating radiation such as ultraviolet, deep-ultraviolet or excimer laser light through a desired mask pattern using a reduction-projection exposure system or subjected to electron beam photolithography, then heated and developed with a developer such as an alkaline aqueous solution, typically a 1 - 10 mass% tetramethylammonium hydroxide (TMAH) aqueous solution, thereby forming a photoresist pattern on the substrate.

The photoresist composition serving as a material from which photoresist patterns are formed is not limited in any particular way and any common photoresist compositions may be employed including those for exposure to i- or g-lines, those for exposure with an excimer laser (e.g. KrF, ArF or F₂) and those for exposure to EB (electron beams).

### [a.] Over-coating agent application step

An over-coating agent is applied to cover entirely the said substrate having photoresist patterns (mask patterns) thereon. After applying the over-coating agent, the substrate may optionally be pre-baked at a temperature of 80 - 100 °C for 30 - 90 seconds.

The over-coating agent may be applied by any methods commonly employed in the conventional heat flow process. Specifically, an aqueous solution of the over-coating agent for forming fine patterns is applied to the substrate by any known application methods including bar coating, roll coating and whirl coating with a spinner.

The over-coating agent employed in the invention is to cover the substrate having photoresist patterns (mask patterns) thereon, including patterns typified by hole patterns or trench patterns, each of these patterns are defined by spacing between the adjacent photoresist patterns (mask patterns). Upon heating, the applied film of the over-coating agent shrinks to increase the width of each of the photoresist patterns, thereby narrowing or lessening hole patterns or trench patterns as defined by spacing between the adjacent photoresist patterns and, thereafter, the applied film is removed completely to form or define fine featured patterns.

In the present invention, the over-coating agent is preferably employed that contains a water-soluble polymer.

The water-soluble polymer may be any polymer that can dissolve in water at room temperature and various types may be employed without particular limitation; preferred examples include acrylic polymers, vinyl polymers, cellulosic derivatives, alkylene glycol polymers, urea polymers, melamine polymers, epoxy polymers and amide polymers.

Exemplary acrylic polymers include polymers and copolymers having monomeric components, such as acrylic acid, methyl acrylate, methacrylic acid, methyl methacrylate, N,N-dimethylacrylamide, N,N-dimethylaminopropylmethacrylamide, N,N-dimethylaminopropylacrylamide, N-methylacrylamide, diacetone acrylamide, N,N-dimethylaminoethyl methacrylate, N,N-diethylaminoethyl methacrylate, N,N-dimethylaminoethyl acrylate, acryloylmorpholine, etc.

Exemplary vinyl polymers include polymers and copolymers having monomeric components, such as N-vinylpyrrolidone, vinyl imidazolidinone, vinyl acetate, etc.

Exemplary cellulosic derivatives include hydroxypropylmethyl cellulose phthalate, hydroxypropylmethyl cellulose acetate phthalate, hydroxypropylmethyl cellulose hexahydrophthalate, hydroxypropylmethyl cellulose acetate succinate, hydroxypropylmethyl cellulose, hydroxypropyl cellulose, hydroxyethyl cellulose, cellulose acetate hexahydrophthalate, carboxymethyl cellulose, ethyl cellulose, methylcellulose, etc.

Exemplary alkylene glycol polymers include addition polymers and copolymers of ethylene glycol, propylene glycol, etc.

Exemplary urea polymers include those having methylolurea, dimethylolurea, ethyleneurea, etc. as components.

Exemplary melamine polymers include those having methoxymethylated melamine, methoxymethylated isobutoxymethylated melamine, methoxyethylated melamine, etc. as components.

Among epoxy polymers and amide polymers, those which are water-soluble may also be employed.

It is particularly preferred to employ at least one member selected from the group consisting of alkylene glycol polymers, cellulosic derivatives, vinyl polymers and acrylic polymers. Acrylic polymers are most preferred since they provide ease in pH adjustment. Copolymers comprising acrylic polymers and water-soluble polymers other than acrylic polymers are also preferred since during heat treatment, the efficiency of shrinking the spacing between the adjacent photoresist patterns (mask patterns) can be increased while maintaining the shape of the photoresist pattern. The water-soluble polymers can be employed either singly or in combination.

When water-soluble polymers are used as copolymers, the proportions of the components are not limited to any particular values. However, if stability over time is important, the proportion of the acrylic polymer is preferably adjusted to be larger than those of other building polymers. Other than by using excessive amounts of the acrylic polymer, better stability over time can also be obtained by adding acidic compounds such as p-toluenesulfonic acid and dodecylbenzenesulfonic acid.

The over-coating agent for forming fine patterns may additionally contain water-soluble amines. Preferred ones include amines having pKa (acid dissociation constant) values of 7.5 - 13 in aqueous solution at 25 °C in view of the prevention of the generation of impurities and pH adjustment. Specific examples include the following: alkanolamines, such as monoethanolamine, diethanolamine, triethanolamine, 2-(2-aminoethoxy)ethanol, N,N-dimethylethanolamine, N,N-diethylethanolamine, N,N-dibutylethanolamine, N-methylethanolamine, N-ethylethanolamine, N-butylethanolamine, N-methyldiethanolamine, monoisopropanolamine, diisopropanolamine and triisopropanolamine; polyalkylenepolyamines, such as diethylenetriamine, triethylenetetramine, propylenediamine, N,N-diethylethylenediamine, 1,4-butanediamine, N-ethyl-ethylenediamine, 1,2-propanediamine, 1,3-propanediamine and 1,6-hexanediamine; aliphatic amines, such as triethylamine, 2-ethyl-hexylamine, dioctylamine, tributylamine, tripropylamine, triallylamine, heptylamine and cyclohexylamine; aromatic amines, such as benzylamine and diphenylamine; and cyclic amines, such as piperazine, N-methyl-piperazine and hydroxyethylpiperazine. Preferred water-soluble amines are those having boiling points of 140 °C (760 mmHg) and above, as exemplified by monoethanolamine and triethanolamine.

If the water-soluble amine is to be added, it is preferably incorporated in an amount of about 0.1 - 30 mass%, more preferably about 2 - 15 mass%, of the over-coating agent (in terms of solids content). If the water-soluble amine is incorporated in an amount of less than 0.1 mass%, the coating fluid may deteriorate over time. If the water-soluble amine is incorporated in an amount exceeding 30 mass%, the photoresist pattern being formed may deteriorate in shape.

The over-coating agent may further optionally contain a surfactant for attaining special effects such as coating uniformity and wafer's in-plane uniformity.

The surfactant is preferably employed that, when added to the water-soluble polymer, exhibits certain characteristics such as high solubility, non-formation of a suspension and miscibility with the polymer component. By using surfactants that satisfy these characteristics, the occurecne of defects can effectively be prevented that is considered to be pertinent to microforming upon applying the over-coating agent.

Preferred suitable surfactant in the invention is at least one member selected among N-alkylpyrrolidones, quaternary ammonium salts and phosphate esters of polyoxyethylene.

N-alkylpyrrolidones as surfactant are preferably represented by the following general formula (I): 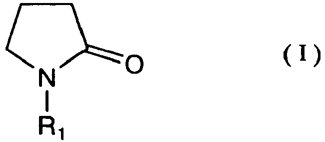 where R₁ is an alkyl group having at least 6 carbon atoms.

Specific examples of N-alkylpyrrolidones as surfactant include N-hexyl-2-pyrrolidone, N-heptyl-2-pyrrolidone, N-octyl-2-pyrrolidone, N-nonyl-2-pyrrolidone, N-decyl-2-pyrrolidone, N-undecyl-2-pyrrolidone, N-dodecyl-2-pyrrolidone, N-tridecyl-2-pyrrolidone, N-tetradecyl-2-pyrrolidone, N-pentadecyl-2-pyrrolidone, N-hexadecyl-2-pyrrolidone, N-heptadecyl-2-pyrrolidone and N-octadecyl-2-pyrrolidone. Among these, N-octyl-2-pyrrolidone ("SURFADONE LP 100" of ISP Inc.) is preferably used.

Quaternary ammonium salts as surfactant are preferably represented by the following general formula (II): 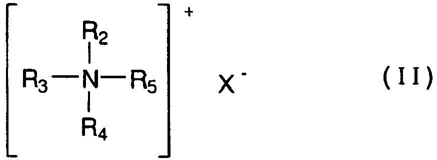 where R₂, R₃, R₄ and R₅ are each independently an alkyl group or a hydroxyalkyl group (provided that at least one of them is an alkyl or hydroxyalkyl group having not less than 6 carbon atoms); X⁻ is a hydroxide ion or a halogenide ion.

Specific examples of quaternary ammonium salts as surfactant include dodecyltrimethylammonium hydroxide, tridecyl-trimethylammonium hydroxide, tetradecyltrimethylammonium hydroxide, pentadecyltrimethylammonium hydroxide, hexadecyltrimethylammonium hydroxide, heptadecyltrimethylammonium hydroxide and octadecyltrimethylammonium hydroxide. Among these, hexadecyltrimethylammonium hydroxide is preferably used.

Phosphate esters of polyoxyethylene are preferably represented by the following general formula (III): 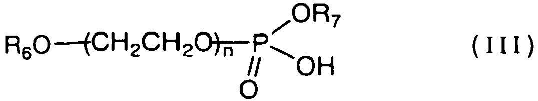 where R₆ is an alkyl or alkylaryl group having 1 - 10 carbon atoms; R₇ is a hydrogen atom or (CH₂CH₂O)R₆ (where R₆ is as defined above); n is an integer of 1 - 20.

To mention specific examples, phosphate esters of polyoxyethylene that can be used as surfactants are commercially available under trade names "PLYSURF A212E" and "PLYSURF A210G" from Dai-ichi Kogyo Seiyaku Co., Ltd.

The amount of the surfactant is preferably about 0.1 - 10 mass%, more preferably about 0.2 - 2 mass%, of the over-coating agent (in terms of solids content). By adopting the amount of the surfactant within the range as described above, it may effectively prevent the variations in the percent shrinkage of patterns, potentially depending on the wafer's in-plane uniformity which is caused by the deterioration of coating property, and also can effectively prevent the generation of defects, which is considered to be pertinent to the occurrence of microfoaming on the applied film.

The over-coating agent used in the invention for forming fine patterns is preferably used as an aqueous solution at a concentration of 3 - 50 mass%, more preferably at 5 - 30 mass%. If the concentration of the aqueous solution is less than 3 mass%, poor coverage of the substrate may result. If the concentration of the aqueous solution exceeds 50 mass%, there is no appreciable improvement in the intended effect that justifies the increased concentration and the solution cannot be handled efficiently.

As already mentioned, the over-coating agent in the invention for forming fine patterns is usually employed as an aqueous solution using water as the solvent. A mixed solvent system comprising water and an alcoholic solvent may also be employed. Exemplary alcoholic solvents include methyl alcohol, ethyl alcohol, propyl alcohol, isopropyl alcohol, glycerol, ethylene glycol, propylene glycol, 1,2-butylene glycol, 1,3-buthylene glycol and 2,3-butylene glycol, etc. These alcoholic solvents are mixed with water in amounts not exceeding about 30 mass%.

### [b.] Heat treatment (thermal shrinkage) step

In the next step, heat treatment is performed to cause thermal shrinkage of the film of the over-coating agent. Under the resulting force of thermal shrinkage of the film, the dimensions of the photoresist pattern in contact with the film will increase by an amount equivalent to the thermal shrinkage of the film and, as the result, the photoresist pattern widens and accordingly the spacing between the adjacent photoresist patterns lessens. The spacing between the adjacent photoresist patterns determines the diameter or width of the pattern elements to be finally obtained, so the decrease in the spacing between the adjacent photoresist patterns contributes to reducing the diameter of each element of hole patterns or the width of each element of trench patterns, eventually leading to the definition of a pattern with smaller feature sizes.

The heating temperature is not limited to any particular value as long as it is high enough to cause thermal shrinkage of the film of the over-coating agent and form or define a fine pattern, but will not cause thermal fluidizing of the photoresist pattern. The temperature that will not cause thermal fluidizing of the photoresist pattern is such a temperature that when a substrate on which the photoresist pattern has been formed but no film of the over-coating agent has been formed is heated, the photoresist pattern will not experience any dimensional changes (for example, dimensional changes due to spontaneously fluidized deforming). Performing a heat treatment under such temperature conditions is very effective for various reasons, e.g. a fine-line pattern of good profile can be formed more efficiently and the duty ratio in the plane of a wafer, or the dependency on the spacing between photoresist patterns in the plane of a wafer, can be reduced. Considering the softening points of a variety of photoresist compositions employed in current photolithographic techniques, the preferred heat treatment is usually performed within a temperature range of about 80 - 160 °C for 30 - 90 seconds, provided that the temperature is not high enough to cause thermal fluidizing of the photoresist.

The thickness of the film of the over-coating agent for the formation of fine-line patterns is preferably just comparable to the height of the photoresist pattern or high enough to cover it. In the fabrication of semiconductor devices, the height of the photoresist pattern is in general about 0.1 - 0.5 µm. In the method of the present invention, fine-line patterns are formed by repeating plural times steps [a.] - [c.], thereby progressively widening the line-width of each element of photoresist patterns. Therefore, the present invention exhibits effect of forming fine-line patterns with good profile even in the case of using a substrate having a thick photoresist patterns in a thick of 1.0 µm or more thereon in the production of magnetic heads and manufacture of microlens arrays.

### [c.] Over-coating agent removal step

In the subsequent step, the remaining film of the over-coating agent on the patterns is removed by washing with an aqueous solvent, preferably pure water, for 10 - 60 seconds. Prior to washing with water, rinsing may optionally be performed with an aqueous solution of alkali (e.g. tetramethylammonium hydroxide (TMAH) or choline). The over-coating agent in the present invention is easy to remove by washing with water and it can be completely removed from the substrate and the photoresist pattern.

The method of the present invention is characterized by repeating plural times steps [a.] - [c.]. By repeating steps plural times [a.] - [c.], the photoresist trace patterns (mask patterns) can be progressively widened. Furthermore, the use of the over-coating agent for forming fine patterns containing a water-soluble polymer allows the over-coating agent be completely removed with water every time in repeating the removal step plural times. Therefore, the present invention offers the advantage that even in the case of using a substrate having thick-film photoresist patterns, fine-line patterns of good profile can be formed on the substrate without causing pattern distortion or deformation.

As a result, each pattern on the substrate has a smaller feature size because each pattern is defined by the narrowed spacing between the adjacent widened photoresist patterns.

The fine-line pattern thus formed by the method of the present invention has a pattern size smaller than the resolution limit attainable by the conventional methods. In addition, it has a good enough profile and physical properties that can fully satisfy the characteristics required of semiconductor devices.

The technical field of the present invention is not limited to the semiconductor industry and it can be employed in a wide range of applications including the fabrication of liquid-crystal display devices, the production of magnetic heads and even the manufacture of microlens arrays.

### EXAMPLES

The following examples are provided for further illustrating the present invention but are in no way to be taken as limiting. Unless otherwise noted, all amounts of ingredients are expressed in mass%.

### EXAMPLE 1

A substrate was whirl coated with a positive-acting photoresist EP-TF004EL (product of Tokyo Ohka Kogyo Co., Ltd.) and baked at 150 °C for 300 seconds to form a photoresist layer in a thickness of 2.0 µm.

The photoresist layer was exposed to trace with an electron beam (EB) lithography equipment (HL-800D of Hitachi, Ltd.), subjected to heat treatment at 140 °C for 300 seconds and developed with an aqueous solution of 2.38 mass% TMAH (tetramethylammonium hydroxide) to form photoresist patterns which defined trench patterns with an each line-width of 258.9 nm (i.e., the spacing between the adjacent photoresist patterns was 258.9 nm).

A copolymer of acrylic acid and vinylpyrrolidone [10g; acrylic acid/vinylpyrrolidone = 2:1 (by weight)] was dissolved in water (90g) to prepare an over-coating agent having the overall solids content adjusted to 10.0 mass% (hereinafter, refer to "over-coating agent 1"). Then thusly prepared over-coating agent 1 was applied onto the substrate including the trench patterns and subjected to heat treatment at 120 °C for 90 seconds. Subsequently, the over-coating agent 1 was removed using pure water at 23 °C. The each line-width of the trench patterns was reduced to 237.5 nm.

Then, the over-coating agent 1 was applied onto the thusly treated substrate including the trench patterns and subjected to heat treatment at 120 °C for 90 seconds. Subsequently, the over-coating agent 1 was removed using pure water at 23 °C. The each line-width of the trench patterns was reduced to 229.6 nm.

And then, the over-coating agent 1 was applied onto the thusly treated substrate including the trench patterns and subjected to heat treatment at 120 °C for 90 seconds. Subsequently, the over-coating agent 1 was removed using pure water at 23 °C. The each line-width of the trench patterns was further reduced to 215.1 nm.

### EXAMPLE 2

A substrate was whirl coated with a positive-acting photoresist DP-TF010PM (product of Tokyo Ohka Kogyo Co., Ltd.) and baked at 130 °C for 150 seconds to form a photoresist layer in a thickness of 3.0 µm.

The photoresist layer was exposed with a KrF excimer laser exposure unit (FPA-3000 EX3 of Canon Inc.), subjected to heat treatment at 120 °C for 150 seconds and developed with an aqueous solution of 2.38 mass% TMAH (tetramethylammonium hydroxide) to form photoresist patterns which defined trench patterns with an each line-width of 204.1 nm (i.e., the spacing between the adjacent photoresist patterns was 204.1 nm).

A copolymer of acrylic acid and vinylpyrrolidone [9.1g; acrylic acid/vinylpyrrolidone = 2:1 (by weight)] and triethanolamine (0.9g) were dissolved in water (90g) to prepare an over-coating agent having the overall solids content adjusted to 10.0 mass% (hereinafter, described as "over-coating agent 2"). Then thusly prepared over-coating agent 2 was applied onto the substrate including the trench patterns and subjected to heat treatment at 110 °C for 90 seconds. Subsequently, the over-coating agent 2 was removed using pure water at 23 °C. The each line-width of the trench patterns was reduced to 185.9 nm.

Then, the over-coating agent 2 was applied onto the thusly treated substrate including the trench patterns and subjected to heat treatment at 110 °C for 90 seconds. Subsequently, the over-coating agent 2 was removed using pure water at 23 °C. The each line-width of the trench patterns was reduced to 175.9 nm.

And then, the over-coating agent 2 was applied onto the thusly treated substrate including the trench patterns and subjected to heat treatment at 110 °C for 90 seconds. Subsequently, the over-coating agent 2 was removed using pure water at 23 °C. The each line-width of the trench patterns was further reduced to 158.9 nm.

### COMPARATIVE EXAMPLE 1

A substrate was whirl coated with a positive-acting photoresist DP-TF010PM (product of Tokyo Ohka Kogyo Co., Ltd.) and baked at 130 °C for 150 seconds to form a photoresist layer in a thickness of 3.0 µm.

The photoresist layer was exposed with a KrF excimer laser exposure unit (FPA-3000 EX3 of Canon Inc.), subjected to heat treatment at 120 °C for 150 seconds and developed with an aqueous solution of 2.38 mass% TMAH (tetramethylammonium hydroxide) to form photoresist patterns which defined trench patterns with an each line-width of 202.7 nm (i.e., the spacing between the adjacent photoresist patterns was 202.7 nm).

Then the over-coating agent 1 was applied onto the substrate including the trench patterns and subjected to heat treatment at 140 °C for 90 seconds. Subsequently, the over-coating agent 1 was removed using pure water at 23 °C.

As a result, the upper portions of the photoresist patterns were deformed, and the trench patterns defined by the photoresist patterns had poor profiles. Thusly obtained substrate could not be subjected to following fabrication steps and accordingly not be adopted commercially.

### Industrial Applicability

As described above in detail, according to the present inventions of the method of forming fine-line patterns, one can obtain fine-line patterns which exhibits a good profile while satisfying the characteristics required of semiconductor devices. The present invention is particularly suitably used for the substrate having thick-film photoresist patterns in a thickness of 1.0 µm or more.

## Claims

1. A method of forming fine patterns on a substrate comprising repeating plural times the following course of steps: covering the substrate having thereon photoresist patterns with an over-coating agent applying heat treatment to cause thermal shrinkage of the over-coating agent the force of the thermal shrinkage causing the dimensions of the photoresist pattern in contact with the over-coating agent to increase and the spacing between the adjacent photoresist patterns to correspondingly decrease, and completely removing the over-coating agent,
wherein the heat treatment is performed at a temperature that does not cause thermal fluidizing of the photoresist patterns on the substrate.

2. The method of forming fine patterns according to claim 1, wherein the over-coating agent contains a water-soluble polymer.

3. The method of forming fine patterns according to claim 2, wherein the water-soluble polymer is at least one member selected from the group consisting of alkylene glycolic polymers, cellulosic derivatives, vinyl polymers, acrylic polymers, urea polymers, epoxy polymers, melamine polymers and amide polymers.

4. The method of forming fine patterns according to claim 2, wherein the water-soluble polymer is at least one member selected from the group consisting of alkylene glycolic polymers, cellulosic derivatives, vinyl polymers and acrylic polymers.

5. The method of forming fine patterns according to claim 1, wherein the over-coating agent is an aqueous solution having a solids content of 3 - 50 mass%.

6. The method of forming fine patterns according to claim 2, wherein the over-coating agent further contains a water-soluble amine, in addition to the water-soluble polymer.

7. The method of forming fine patterns according to claim 6, wherein the water-soluble amine has pKa (acid dissociation constant) values of 7.5 - 13 in aqueous solution at 25 °C.

8. The method of forming fine patterns according to claim 6, wherein the water-soluble amine is contained in an amount of 0.1 - 30 mass% in the over-coating agent (as solids).

9. The method of forming fine patterns according to claim 1, wherein the over-coating agent is removed with water.

10. The method of forming fine patterns according to claim 1, wherein photoresist patterns on the substrate have a thickness of 1.0 µm or more.

## Patentansprüche

1. Verfahren zur Herstellung feiner Muster auf einem Substrat, umfassend mehrfach wiederkehrend den folgenden Verlauf von Schritten: Bedecken des Substrats mit Fotoresist-Mustern darauf mit einem Überzugsmittel, Anwenden einer Wärmebehandlung, um eine thermische Schrumpfung des Überzugsmittels hervorzurufen, wobei die Kraft der thermischen Schrumpfung bewirkt, dass sich die Abmessungen des Fotoresist-Musters in Kontakt mit dem Überzugsmittel vergrößern und sich die Abstände zwischen benachbarten Fotoresist-Mustern entsprechend verringern, und vollständiges Entfernen des Überzugsmittels, wobei die Wärmebehandlung bei einer Temperatur durchgeführt wird, die keine thermische Verflüssigung der Fotoresist-Muster auf dem Substrat bewirkt.

2. Verfahren zur Herstellung feiner Muster gemäß Anspruch 1, wobei das Überzugsmittel ein wasserlösliches Polymer enthält.

3. Verfahren zur Herstellung feiner Muster gemäß Anspruch 2, wobei das wasserlösliche Polymer mindestens ein Mitglied, ausgewählt aus der Gruppe bestehend aus Alkylenglycolpolymeren, Cellulosederivaten, Vinylpolymeren, Acrylpolymeren, Harnstoffpolymeren, Epoxypolymeren, Melaminpolymeren und Amidpolymeren, ist.

4. Verfahren zur Herstellung feiner Muster gemäß Anspruch 2, wobei das wasserlösliche Polymer mindestens ein Mitglied, ausgewählt aus der Gruppe bestehend aus Alkylenglycolpolymeren, Cellulosederivaten, Vinylpolymeren und Acrylpolymeren, ist.

5. Verfahren zur Herstellung feiner Muster gemäß Anspruch 1, wobei das Überzugsmittel eine wässrige Lösung mit einem Feststoffgehalt von 3 bis 50 Massen% ist.

6. Verfahren zur Herstellung feiner Muster gemäß Anspruch 2, wobei das Überzugsmittel ferner ein wasserlösliches Amin zusätzlich zu dem wasserlöslichen Polymer enthält.

7. Verfahren zur Herstellung feiner Muster gemäß Anspruch 6, wobei das wasserlösliche Amin pKa-Werte (Säuredissoziationskonstanten) von 7,5 bis 13 in wässriger Lösung bei 25°C hat.

8. Verfahren zur Herstellung feiner Muster gemäß Anspruch 6, wobei das wasserlösliche Amin in einer Menge von 0,1 bis 30 Massen% in dem Überzugsmittel (als Feststoffe) enthalten ist.

9. Verfahren zur Herstellung feiner Muster gemäß Anspruch 1, wobei das Überzugsmittel mit Wasser entfernt wird.

10. Verfahren zur Herstellung feiner Muster gemäß Anspruch 1, wobei die Fotoresist-Muster auf dem Substrat eine Dicke von 1,0 *µ*m oder mehr haben.

## Revendications

1. Procédé de formation de motifs fins sur un substrat comprenant la répétition plusieurs fois de la suite d'étapes suivante: revêtement du substrat ayant sur lui des motifs de photorésist avec un agent de sur-revêtement, application d'un traitement thermique pour provoquer un retrait thermique de l'agent de sur-revêtement, la force du retrait thermique provoquant une augmentation des dimensions du motif de photorésist en contact avec l'agent de sur-revêtement et une diminution correspondante de l'écart entre les motifs de photorésist adjacents et retrait total de l'agent de sur-revêtement, où le traitement thermique est accompli à une température qui ne provoque pas de fluidisation thermique des motifs de photorésist sur le substrat.

2. Procédé de formation de motifs fins selon la revendication 1 où l'agent de sur-revêtement contient un polymère soluble dans l'eau.

3. Procédé de formation de motifs fins selon la revendication 2 où le polymère soluble dans l'eau est au moins un membre choisi dans le groupe consistant en les polymères alkylèneglycoliques, les dérivés cellulosiques, les polymères vinyliques, les polymères acryliques, les polymères d'urée, les polymères d'époxyde, les polymères de mélamine et les polymères d'amide.

4. Procédé de formation de motifs fins selon la revendication 2 où le polymère soluble dans l'eau est au moins un membre choisi dans le groupe consistant en les polymères alkylèneglycoliques, les dérivés cellulosiques, les polymères vinyliques et les polymères acryliques.

5. Procédé de formation de motifs fins selon la revendication 1 où l'agent de sur-revêtement est une solution aqueuse ayant une teneur en solides de 3 - 50 % en masse.

6. Procédé de formation de motifs fins selon la revendication 2 où l'agent de sur-revêtement contient en outre une amine soluble dans l'eau, en plus du polymère soluble dans l'eau.

7. Procédé de formation de motifs fins selon la revendication 6 où l'amine soluble dans l'eau a des valeurs de pKa (constante de dissociation d'acide) de 7,5 - 13 en solution aqueuse à 25°C.

8. Procédé de formation de motifs fins selon la revendication 6 où l'amine soluble dans l'eau est contenue en une quantité de 0,1 - 30 % en masse dans l'agent de sur-revêtement (en solides).

9. Procédé de formation de motifs fins selon la revendication 1 où l'agent de sur-revêtement est retiré avec de l'eau.

10. Procédé de formation de motifs fins selon la revendication 1 où les motifs de photorésist sur le substrat ont une épaisseur de 1,0 µm ou plus.
